Europäisches Patentamt

European Patent Office

Office européen des brevets

(11) Publication number: **0 226 995**
**A2**

# EUROPEAN PATENT APPLICATION

(21) Application number: 86117418.3

(22) Date of filing: 15.12.86

(51) Int. Cl.⁴: **G01R 1/073**

(30) Priority: 23.12.85 US 812145

(43) Date of publication of application:
**01.07.87 Bulletin 87/27**

(84) Designated Contracting States:
**DE FR GB NL**

(71) Applicant: **TEKTRONIX, INC.**
**Tektronix Industrial Park D/S Y3-121 4900**
**S.W. Griffith Drive P.O. Box 500**
**Beaverton Oregon 97077(US)**

(72) Inventor: **Garuts, Valdis E.**
**14170 S.W. 22nd Street**
**Beaverton Oregon 97005(US)**
Inventor: **Creedon, Theodore G.**
**5740 S.W. Childs Road**
**Lake Oswego Oregon 97034(US)**

(74) Representative: **Baillie, Iain Cameron et al**
**c/o Ladas & Parry Isartorplatz 5**
**D-8000 München 2(DE)**

(54) **Multiple lead probe for integrated circuits.**

(57) A probe assembly for use in testing an integrated circuit embodied in an integrated circuit chip, comprises a stiff support member formed with an aperture, and an elastically-deformable membrane. Both the support member and the membrane comprise dielectric material and portions of conductive material supported by the dielectric material in electrically-insulated relationship. The portions of conductive material of the membrane constitute inner contact elements distributed over a face of the membrane in a pattern that corresponds to the pattern in which contact areas are distributed over the contact face of the chip under test, outer contact elements exposed about a peripheral region of the membrane in a second pattern, and transmission lines extending from the inner contact elements to the outer contact elements respectively. The portions of conductive material of the support member comprise inner contact elements exposed in a pattern corresponding to the second pattern, and transmission lines extending from the inner contact elements of the support member for connection to testing apparatus. The membrane is secured to the support member in a manner such that the membrane overlies the aperture in the support member and the outer contact elements of the membrane are in electrically-conductive contact with respective inner contact elements of the support member.

FIG. I

## MULTIPLE LEAD PROBE FOR INTEGRATED CIRCUITS

This invention relates to a multiple lead probe for integrated circuits.

### Background of the Invention

An important aspect of the manufacture of integrated circuit chips is the testing of the circuit embodied in the chip in order to verify that it operates according to specifications. Although the circuit could be tested after the chip has been packaged, the expense involved in dicing the wafer and packaging the individual chips makes it desirable to test the integrated circuit as early as possible in the fabrication process, so that unneccessary efforts will not be expended on faulty devices. It is therefore desirable that these circuits be tested either immediately after wafer fabrication is completed, and before separation into dice, or after dicing but before packaging. In either case, it is necessary to make electrical connections to all the circuit's external connections (usually bonding pads) in a nondestructive way, so as not to interfere with subsequent packaging and connection operations.

It is desirable that an integrated circuit be tested under its design operating conditions and to the extremes of its design performance range. In particular, typical high speed circuits are designed to operate with input and output signal bandwidths exceeding 1 GHz, and it is necessary that operation of such circuits be evaluated at these high frequencies.

A high speed wafer probe is disclosed in U. S. Patent Application Serial No. 318,084 filed November 4, 1981. A practical implementation of the probe disclosed in that patent application is capable of supporting signal bandwidths to approximately 18 GHz, but is able to provide only a few - (less than ten) connections to the chip under test. Probes that are able to provide sufficient connections for the complex integrated circuits that are currently being manufactured, having fifty to one thousand bonding pads, have inadequate bandwidth for testing high speed circuits at the extremes of their performance range.

### Summary of the Invention

A probe for use in testing an integrated circuit embodied in an integrated circuit chip comprises a stiff support member and an elastically-deformable membrane. Both the support member and the membrane comprise dielectric material and portions of conductive material supported by the dielectric material in electrically-insulated relationship. The portions of conductive material of the membrane constitute inner contact elements distributed over a face of the membrane in a first pattern that corresponds to the pattern of contact areas on the contact face of the integrated circuit chip, outer contact elements distributed about a peripheral region of the membrane in a second pattern and exposed at one main face of the membrane, and transmission lines extending from the inner contact elements to the outer contact elements respectively. The portions of conductive material of the support member comprise inner contact elements that are exposed in a pattern corresponding to the second pattern, and transmission lines extending from the inner contact elements of the support member to testing apparatus. The probe also comprises means for securing the membrane to the support member in a manner such that the outer contact elements of the membrane are in electrically-conductive contact with respective inner contact elements of the support member. The support member has an aperture over which the membrane extends when it is secured to the support member.

### Brief Description of the Drawings

For a better understanding of the invention, and to show how the same may be carried into effect, reference will now be made, by way of example, to the accompanying drawings in which:

FIG. 1 is a side view, partly in section and partly in elevation, of a probe assembly comprising a membrane probe head and a printed circuit board,

FIG. 2 is a bottom plan view of the probe assembly,

FIG. 3 is an enlarged sectional view illustrating the structure of the membrane and the connection between the membrane and the circuit board,

FIG. 4 is an enlarged top plan view of a part of FIG. 3,

FIG. 5 is a partial top plan view to a reduced scale showing the circuit board and a mechanical support structure, and

FIG. 6 shows an enlarged view of the detail A of FIG. 5.

## Detailed Description

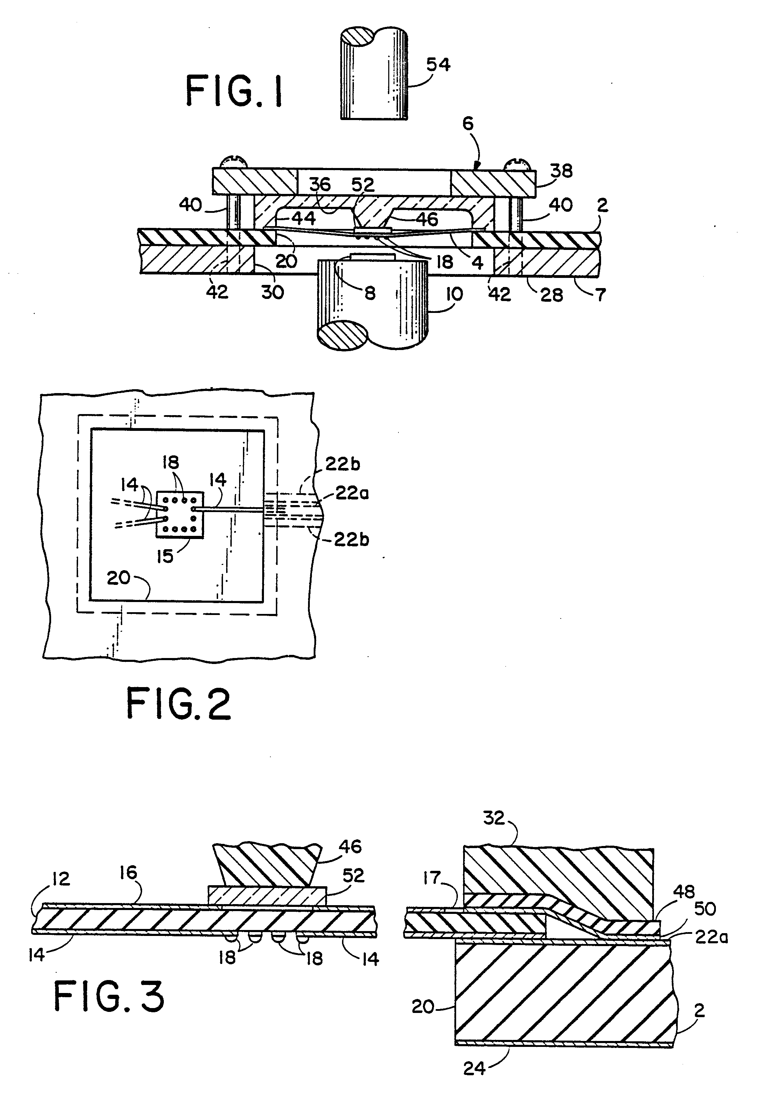

the probe assembly shown in FIG. 1 comprises a printed circuit board 2, a film probe head 4, a mounting device 6 and a mechanical support structure 7. An integrated circuit chip 8 that is to be tested is mounted on a chip support 10. The chip has contact pads (not shown) distributed over its upper face. The face of the chip over which the contact pads are distributed is referred to herein as the contact face of the chip.

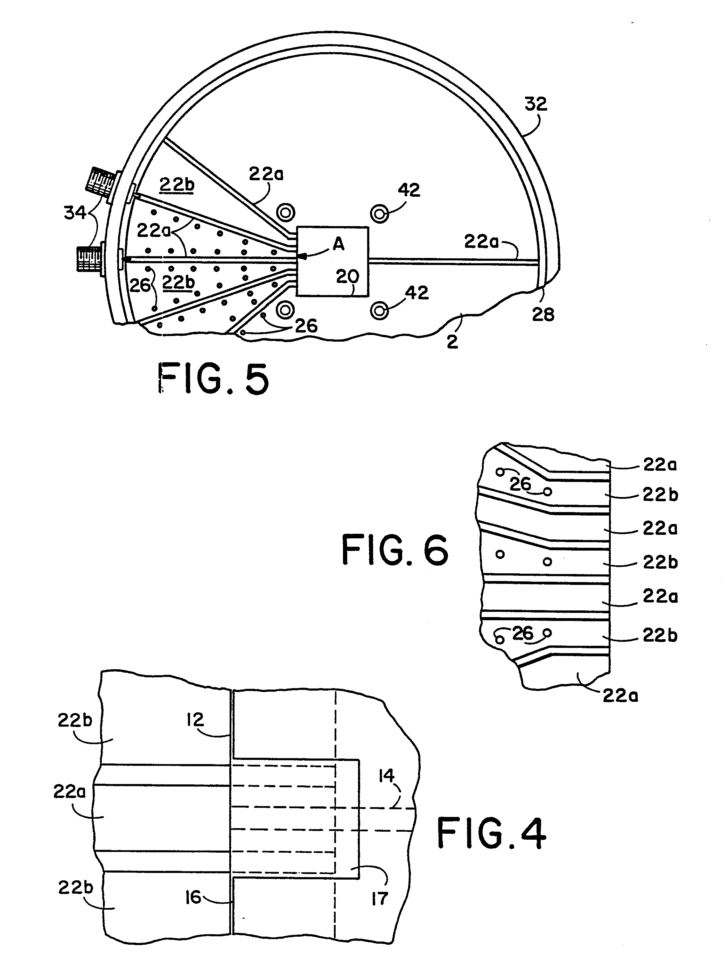

The probe head 4 comprises a film 12 (FIG. 3) of flexible, transparent dielectric material, such as polyimide. A pattern of electrically conductive material is formed on the film 12 using standard photolithographic patterning and etching techniques. The pattern of conductive material comprises conductor runs 14 on the underside of the film 12 and a continuous ground plane 16 on the upper side of the film. The conductor runs 14 extend between a central area 15 of the film 12 and a peripheral area of the film, and contact bumps 18 of a wear resistant material are formed at the inner ends of the conductor runs 14 by conventional masking and plating techniques. The geometric distribution of the contact bumps 18 over the underside of the film 12 corresponds to the geometric distribution of contact pads over the contact face of the chip 8. Therefore, the bumps 18 can be brought into electrically-conductive pressure contact with respective contact pads of the chip. The ground plane 16 extends over the entire upper surface of the film 12, except for the central area 15 and indentations 17 (FIGS. 3 and 4) at the periphery of the film. The central area of the film is left uncovered by the ground plane in order to facilitate viewing of the contact bumps from above the membrane. The purpose of the ground plane indentations 17 is described hereinafter. When the probe head is in use, the ground plane 16 is grounded, and therefore the conductor runs 14 and the ground plane 16 together constitute transmission lines extending from the contact bumps 18 to the peripheral area of the film.

The printed circuit board 2 is circular and is formed with a window 20 and comprises conductor runs 22 that extend between the periphery of the window 20 and the outer periphery of the board. The conductor runs are in two main groups, namely signal runs 22a and ground runs 22b. The conductor runs are exposed at the upper surface of the board 2 about the periphery of the window 20, and are also exposed at the outer periphery of the board. The lower surface of the board is covered by a continuous ground plane 24, to which the ground conductor runs 22b are connected by plated throughholes 26 (FIG. 6).

The support structure 7 comprises a circular plate 28 that is formed with an opening 30 which is somewhat larger than the window 20 in the circuit board 2. Around its periphery, the plate is provided with an upstanding annulus 32. Thus, the circuit board 2 is received in a circular recess defined by the support structure 7. The annulus 32 carries coaxial connectors 34, only two of which are shown in FIG. 5, having their inner conductors connected to respective signal conductor runs 22a of the circuit board. The outer conductors of the connectors 34 are grounded through the support structure 7, which is also connected to, and grounds, the lower ground plane 24. The spacing between the conductors 22a and 22b is such that the conductors 22b form a transmission line with each of the signal conductors 22a.

The film probe head 4 is positioned to extend over the window 20, with its lower surface contacting the upper surface of the circuit board 2. The conductor runs of the probe head and the circuit board are arranged so that each of the runs 14 contacts one of the signal runs 22a, but does not bridge the space between the run 22a and either of the adjacent ground conductor runs 22b. The mounting device 6 is used to hold the probe head in position relative to the circuit board.

The mounting device 6 comprises a moulding 36 of transparent elastomeric material and a pressure plate 38. Mounting screws 40 extend through holes in the pressure plate and the board to engage internally threaded holes 42 in the place 28. The elastomeric body has a ridge 44 extending around its lower periphery. Therefore, upon tightening the screws the elastomeric body 32 is compressed and clamps the peripheral region of the probe head to the circuit board. In this manner, the conductor runs 14 are brought into direct pressure contact with the conductor runs 22a. An additional flexible film frame 48 spanning between the probe film 4 and the board 2 around the periphery of the probe film 4 has conductive elements 50 on its underside. The conductive elements are in the form of discrete strips that extend transversely across the bottom face of the film frame. The elements 50 serve to establish electrical connection between the conductors 22b and the ground plane 16. The indentations 17 ensure that the elements 50 do not connect the conductors 22a to the ground plane 16. The width and spacing of the elements 50 are selected so that they do not bridge the spacing between the conductors 22a and the adjacent conductors 22b. The pillar 46 engages a transparent hard plastic pressure pad 52, which is secured to the film over the central area 15, and limits upward movement of the contact bumps 18 in resiliently yieldable fashion.

In use of the illustrated probe assembly, a microscope 54 is used in conjunction with an X-Y - (horizontal) positioning mechanism (not shown) to position the contact bumps 18 immediately over the appropriate connection pads of the chip 8. A Z (vertical) positioning mechanism is then used to bring about relative vertical movement between the probe assembly and the chip support so as to establish pressure contact between the contact bumps 18 and the appropriate connection pads. Contact force is provided by the body 36, and particularly the pillar 46. The flexibility of the probe head and the elastomeric body 36 ensures that the pressure contact will not damage the chip, and also compensates for minor variations in the vertical positions of the connection pads and/or the contact surfaces of the bumps 18.

The characteristic impedance of the transmission lines of the probe head is matched to that of the transmission lines of the circuit board, and therefore a high integrity signal path is provided between the contact pads of the chip and the coaxial connectors 34.

The illustration probe assembly provides several advantages over known probe assemblies. For example it is possible to provide as many as 100 high integrity connections to a single integrated circuit without difficulty. The probe head itself is inexpensive and readily replaceable and can be manufactured using conventional techniques. In addition, since the probe head is flexible it is not easily damaged by contact with the chip under test and such contact does not damage the chip.

It will be appreciated that the present invention is not restricted to the particular probe assembly that has been described and illustrated, and that variations may be made therein without departing from the scope of the invention as defined in the appended claims and equivalents thereof. For example, although the transmission lines of the probe head 4 are of microstripline geometry, other geometries are possible. Moreover, although the ground plane 16 is on the top surface of the film 12 and the signal conductor runs 14 are on the lower surface, the reverse arrangement could be used, with the ground plane interposed between the chip 8 and the signal conductor runs 14, if the contact bumps 18 were plated through vias in the film 12. This alternative arrangement provides shielding between the conductor runs and the chip, and also provides access to the signal conductors for mounting active circuit elements in the signal path. Such an active element, e.g. a high input impedance amplifier, may be used to provide a high impedance load to the circuit under test while using a low impedance transmission line for conducting signals to the coaxial connectors. If an automatic stepping mechanism is used for positioning the chip relative to the probe assembly, it is not necessary that the probe head be transparent. Of course, the contact pads of the chip 8 may be at the interior of the contact face as well as about the periphery of the contact face.

## Claims

1. A probe assembly for use in testing an integrated circuit embodied in an integrated circuit chip, comprising a stiff support member formed with an aperture, and an elastically-deformable membrane, both the support member and the membrane comprising dielectric material and portions of conductive material supported by the dielectric material in electrically-insulated relationship, the portions of conductive material of the membrane constituting a plurality of inner contact elements distributed over a face of the membrane in a pattern that corresponds to the pattern in which contact areas are distributed over the contact face of the chip under test, a plurality of outer contact elements exposed about a peripheral region of the membrane in a second pattern, and a plurality of transmission lines extending from said inner contact elements to said outer contact elements respectively, and the portions of conductive material of the support member comprising a plurality of inner contact elements exposed in a pattern corresponding to said second pattern, and a plurality of transmission lines extending from the inner contact elements of the support member for connection to testing apparatus, and the probe assembly also comprising means for securing the membrane to the support member in a manner such that the membrane overlies said aperture and the outer contact elements of the membrane are in electrically-conductive contact with respective inner contact elements of the support member.

2. A probe assembly according to claim 1, wherein said support member comprises a printed circuit board and the portions of conductive material of the circuit board constitute a plurality of coplanar transmission lines.

3. A probe assembly according to claim 1, wherein the outer contact elements of the membrane are exposed at one main face of the membrane and the transmission lines that are constituted by the portions of conductive material of the membrane are microstripline transmission lines, comprising conductor runs at said one main face of the membrane and a ground plane at the opposite main face of the membrane.

4. A probe assembly according to claim 1, wherein the means for securing the membrane to the support member comprise a clamping member, a body of elastomeric material carried by the clamping member, and means for urging the clamping member towards the support member with the membrane between the body of elastomeric material and the support member, whereby compression of the elastomeric material provides contact pressure for holding the membrane in contact with the support member.

5. A probe assembly according to claim 4, wherein the outer contact elements of the membrane are exposed at one main face of the membrane and the inner contact elements of the support member are exposed at one main face of the support member, and said one main face of the membrane and said one main face of the support member are in confronting relationship, whereby a direct, electrically-conductive pressure contact is established between the outer contact elements of the membrane and the inner contact elements of the support member.

6. A probe assembly according to claim 5, wherein the transmission lines that are formed by portions of electrically conductive material of the membrane comprise conductor runs at said one main face of the membrane and a ground plane at the opposite main face, the ground plane being exposed about the peripheral region of the membrane, and wherein the transmission lines of the support member are constituted by signal conductor runs at said one main face of the support member and ground conductor runs also at said one main face of the support member, and wherein the probe assembly also comprises conductive elements for connecting said ground plane to said ground conductor runs.

7. A probe assembly according to claim 4, wherein the body of elastomeric material includes a portion that engages the membrane at the face of the membrane opposite that at which the inner contact elements of the membrane are exposed, whereby movement of the inner contact elements in the direction towards said portion of the body of elastomeric material is resisted in resiliently yieldable fashion.

8. A probe assembly for use in testing an integrated circuit embodied in an integrated circuit chip, comprising a stiff support member formed with an aperture, and an elastically-deformable membrane, both the support member and the membrane comprising dielectric material and portions of conductive material supported by the dielectric material in electrically-insulated relationship, the portions of conductive material of the membrane constituting a plurality of contact bumps distributed over a face of the membrane in a pattern that corresponds to the pattern in which contact areas are distributed over the contact face of the chip under test, a plurality of outer contact elements distributed about a peripheral region of the membrane in a second pattern and exposed at one main face of the membrane, and a plurality of transmission lines extending from said contact bumps to said outer contact elements respectively, and the portions of conductive material of the support member comprising a plurality of inner contact elements exposed at one main face of the support member in a pattern corresponding to said second pattern, and a plurality of transmission lines extending from the inner contact elements of the support member for connection to testing apparatus, and the probe assembly also comprising means for securing the membrane to the support member in a manner such that the membrane overlies said aperture and the outer contact elements of the membrane are in electrically-conductive contact with respective inner contact elements of the support member.

FIG. I

FIG. 2

FIG. 3

FIG. 5

FIG. 6

FIG. 4